(19) Europäisches Patentamt
European Patent Office
Office européen des brevets

(11) EP 4 130 073 A1

(12) EUROPEAN PATENT APPLICATION
published in accordance with Art. 153(4) EPC

(43) Date of publication:
**08.02.2023 Bulletin 2023/06**

(21) Application number: **21774913.4**

(22) Date of filing: **02.03.2021**

(51) International Patent Classification (IPC):
***C08F 290/06*** *(1995.01)* ***C08F 228/04*** *(1974.07)*
***H01L 21/027*** *(1990.01)*

(52) Cooperative Patent Classification (CPC):
**C08F 228/04; C08F 290/06; H01L 21/027**

(86) International application number:
**PCT/JP2021/008009**

(87) International publication number:
**WO 2021/192858 (30.09.2021 Gazette 2021/39)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **26.03.2020 JP 2020056428**

(71) Applicant: **Sumitomo Seika Chemicals Co., Ltd.**
**Kako-gun, Hyogo 675-0145 (JP)**

(72) Inventor: **MURAKAMI Shinya**
**Kako-gun, Hyogo 675-0145 (JP)**

(74) Representative: **Vossius & Partner**
**Patentanwälte Rechtsanwälte mbB**
**Siebertstraße 3**
**81675 München (DE)**

# (54) PHOTOSENSITIVE RESIN COMPOSITION, MOLDED ARTICLE THAT IS PROVIDED WITH PATTERN, AND METHOD FOR PRODUCING MOLDED ARTICLE THAT IS PROVIDED WITH PATTERN

(57) Disclosed is a photosensitive resin composition containing a polymerizable component and used to form a resin layer in an imprint method including forming a reverse pattern of a pattern of a mold on a resin layer by using the mold having the pattern. The polymerizable component contains an organic sulfur compound. A viscosity of the photosensitive resin composition at 25°C is less than 20 mPa·s.

***Fig.1***

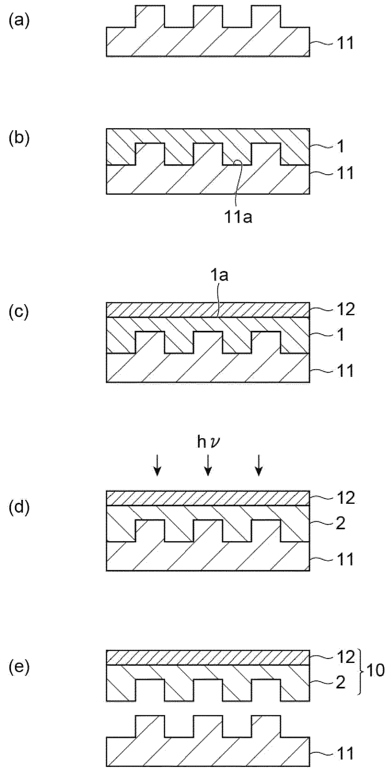


EP 4 130 073 A1

## Description

### Technical Field

The present invention relates to a photosensitive resin composition, a molded article that is provided with a pattern, and a method for producing a molded article that is provided with a pattern.

### Background Art

In recent years, as a next-generation lithography technique, a technique implemented by an imprint method (also called a nanoimprint method) that enables microfabrication has drawn attention. Examples of optical devices prepared by the imprint method include an antireflection film on which a moth-eye structure is formed, a brightness enhancement film on which prism arrays are formed, microlens arrays, a dispersive element on which a lattice pattern is formed, and the like. Most of these devices utilize the refraction or diffraction of light, and the shape of the microstructure or the refractive index of the material forming the microstructure is an important factor that affects the performance.

Patent Literature 1 discloses an imprint material that forms a film having a high refractive index by using a predetermined acrylic compound. Patent Literature 2 describes that a photocurable composition containing an episulfide compound and a photobase generator is used to provide an optical device having a high refractive index.

In the imprint method, a mold (die) having a pattern is used, and a reverse pattern of the pattern is transferred to a layer containing a curable resin (resin layer) or the like. At this time, it is important to accurately transfer the formed pattern to the resin layer, prevent the pattern from being deformed even after the resin layer is cured, and maintain the pattern shape. Non-Patent Literature 1 discloses, as a thermosetting resin, a resin that has a high refractive index and shrinks little after curing. According to Non-Patent Literature 1, the resin shrinks after curing to prevent deformation of the pattern.

### Citation List

### Patent Literature

[Patent Literature 1] Japanese Unexamined Patent Publication No. 2013-095833
[Patent Literature 2] Japanese Unexamined Patent Publication No. 2012-068376

### Non Patent Literature

[Non-Patent Literature 1] Journal of Materials Chemistry C, August 2018, DOI: 10.1039/c8tc02029a

### Summary of Invention

### Technical Problem

As disclosed in Non-Patent Literature 1, for thermosetting resins, resins that are unlikely to cause pattern deformation by an imprint method are being studied. However, studies on the case of using a photocurable resin (also called a photosensitive resin) are still lacking. For example, with the imprint material in Patent Literature 1, it is difficult to form a precise pattern because this material undergoes significant volume shrinkage at the time of curing and has a high water absorption rate. The photocurable resin composition in Patent Literature 2 also shrinks much after curing, which may cause pattern deformation after molding.

One aspect of the present invention is to provide a photosensitive resin composition that is used for a resin layer in an imprint method, contains a compound having a sulfur atom, and makes it possible to obtain a resin layer on which a pattern can be well formed.

### Solution to Problem

One aspect of the present invention provides a photosensitive resin composition containing a polymerizable component and used to form a resin layer in an imprint method including forming a reverse pattern of a pattern of a mold on a resin layer by using the mold having the pattern. The polymerizable component contains an organic sulfur compound. A viscosity of the photosensitive resin composition at 25°C is less than 20 mPa·s.

In order to accurately transfer the pattern from the mold to the resin layer, the pattern shape of the mold (for example, the shape of unevenness) needs to be filled with the resin composition without gaps. In order that the pattern formed on the uncured resin layer is well maintained even after curing, the resin composition needs to be unlikely to shrink and crack when cured. Using such a photosensitive resin composition makes it possible to fill the pattern with the uncured photosensitive resin composition without gaps and to accurately form a pattern. Because this photosensitive resin composition can prevent shrinkage and cracking after curing, the pattern can be well maintained even in the resin layer after curing.

A refractive index nD of the photosensitive resin composition at a wavelength of 589 nm at 25°C may be 1.65 or more. In a case where the refractive index nD is in this range, the refractive index of an imprinted molded article to be obtained can also be increased.

In this photosensitive resin composition, a refractive index nD of the organic sulfur compound at a wavelength of 589 nm at 25°C may be 1.67 or more, and a viscosity of the organic sulfur compound at 25°C may be less than 30 mPa·s.

The organic sulfur compound may contain a compound represented by Formula (1).

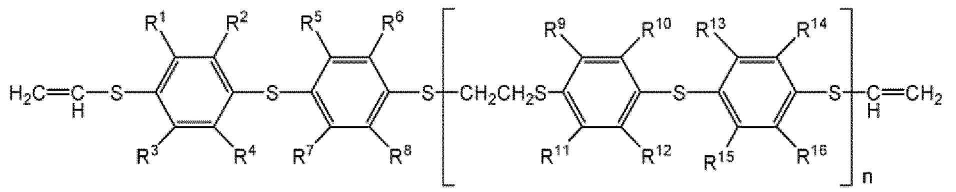

(1)

In Formula (1) $R^1$, $R^2$, $R^3$, $R^4$, $R^5$, $R^6$, $R^7$, $R^8$, $R^9$, $R^{10}$, $R^{11}$, $R^{12}$, $R^{13}$, $R^{14}$, $R^{15}$, and $R^{16}$ may be the same as or different from each other and each represent a hydrogen atom, a halogen atom, or an alkyl group having 1 to 6 carbon atoms, and n represents an integer of 0 to 10.

At this time, the polymerizable component may further contain other polymerizable compounds excluding the compound represented by Formula (1). Those other polymerizable compounds may be at least one kind of compound selected from the group consisting of a (meth)acrylic acid ester and a thio(meth)acrylic acid ester.

The content of the organic sulfur compound may be 50% by mass or more based on the total amount of the polymerizable component.

The photosensitive resin composition may further contain a radical polymerization initiator.

A refractive index nD that a cured material formed by curing the photosensitive resin composition has at a wavelength of 589 nm at 25°C may be 1.70 or more. A cure shrinkage rate of the cured material formed by curing the photosensitive resin composition may be less than 10%.

Another aspect of the present invention provides a molded article that is provided with a pattern and includes a cured material formed by curing the aforementioned photosensitive resin composition. Because the photosensitive resin composition is used in the molded article, even a fine pattern can be accurately formed on the resin layer, and pattern deformation (pattern collapse resulting from shrinkage or cracking) after curing is prevented.

Another aspect of the present invention provides a method for producing a molded article that is provided with a pattern, the method comprising forming a resin layer having a reverse pattern of a pattern of a mold by using the mold having the pattern and irradiating the resin layer with light. The resin layer contains the aforementioned photosensitive resin composition. Because the aforementioned photosensitive resin composition is used in the production method, a molded article that is provided with a good pattern can be easily produced.

## Advantageous Effects of Invention

According to the present invention, it is possible to provide a photosensitive resin composition that is used for a resin layer in an imprint method, contains a compound having a sulfur atom, and makes it possible to obtain a resin layer on which a pattern can be well formed.

## Brief Description of Drawings

Fig. 1 is a schematic cross-sectional view showing an embodiment of a method for producing a molded article that is provided with a pattern.

Fig. 2 is a schematic cross-sectional view showing another embodiment of the method for producing a molded article that is provided with a pattern.

## Description of Embodiments

Hereinafter, some embodiments of the present invention will be specifically described. However, the present invention is not limited to the following embodiments.

In the present specification, "(meth)acryl" means "acryl" and "methacryl".

<Photosensitive Resin Composition>

The photosensitive resin composition according to an embodiment is a composition used as a resin layer on which a pattern is formed in an imprint method including forming a resin layer having a reverse pattern of a pattern of a mold by using the mold having the pattern. In other words, the photosensitive resin composition is an imprint material. Specific embodiments of the imprint method will be described later.

The photosensitive resin composition contains a polymerizable component. The polymerizable component is a compound having a polymerizable group. The polymerizable group is, for example, a group having a polymerizable unsaturated double bond, and may be a radically polymerizable group that reacts by a radical. Examples of the radically polymerizable group include a vinyl group, an allyl group, an alkenyl group, and a (meth)acryloyl group.

The polymerizable component contains an organic sulfur compound. The organic sulfur compound is a compound having a polymerizable group and a sulfur atom.

In an embodiment, the organic sulfur compound includes a vinyl sulfide compound that has a vinyl group as a polymerizable group and has a sulfide skeleton. From the viewpoint of making it easy to form a good pattern on the resin layer, the vinyl sulfide compound may be a compound represented by Formula (1). That is, in an embodiment, the polymerizable component in the photosensitive resin composition contains a compound represented by Formula (1) as an organic sulfur compound.

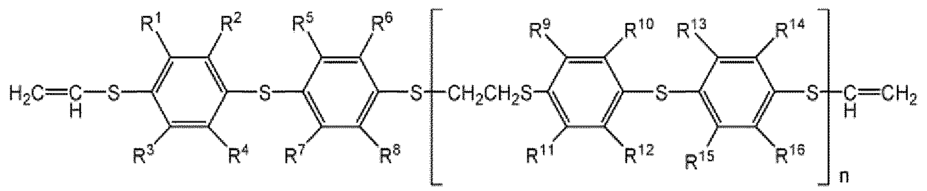 (1)

In Formula (1) $R^1$, $R^2$, $R^3$, $R^4$, $R^5$, $R^6$, $R^7$, $R^8$, $R^9$, $R^{10}$, $R^{11}$, $R^{12}$, $R^{13}$, $R^{14}$, $R^{15}$, and $R^{16}$ may be the same as or different from each other and each represent a hydrogen atom, a halogen atom, or an alkyl group having 1 to 6 carbon atoms, and n represents an integer of 0 to 10.

In Formula (1), the halogen atom represented by $R^1$, $R^2$, $R^3$, $R^4$, $R^5$, $R^6$, $R^7$, $R^8$, $R^9$, $R^{10}$, $R^{11}$, $R^{12}$, $R^{13}$, $R^{14}$, $R^{15}$, or $R^{16}$ ($R^1$ to $R^{16}$) may be a chlorine atom, a bromine atom, or an iodine atom.

Examples of the alkyl group having 1 to 6 carbon atoms represented by $R^1$ to $R^{16}$ in Formula (1) include a methyl group, an ethyl group, a n-propyl group, an isopropyl group, a n-butyl group, a sec-butyl group, a tert-butyl group, a n-pentyl group, and a n-hexyl group.

Any of $R^1$ to $R^{16}$ in Formula (1) may be a hydrogen atom. n in Formula (1) may be 0 to 5, 0 or 1, or 0.

Examples of the compound represented by Formula (1) include bis(4-vinylthiophenyl)sulfide, bis(3-methyl-4-vinylthiophenyl)sulfide, bis(3,5-dimethyl-4-vinylthiophenyl)sulfide, bis(2,3,5,6-tetramethyl-4-vinylthiophenyl)sulfide, bis(3-hexyl-4-vinylthiophenyl)sulfide, bis(3,5-dihexyl-4-vinylthiophenyl)sulfide, bis(3-chloro-4-vinylthiophenyl)sulfide, bis(3,5-dichloro-4-vinylthiophenyl)sulfide, bis(2,3,5,6-tetrachloro-4-vinylthiophenyl)sulfide, bis(3-bromo-4-vinylthiophenyl)sulfide, bis(3,5-dibromo-4-vinylthiophenyl)sulfide, and bis(2,3,5,6-tetrabromo-4-vinylthiophenyl)sulfide.

The compound represented by Formula (1) may be bis(4-vinylthiophenyl)sulfide, bis(3-methyl-4-vinylthiophenyl)sulfide, or bis(3,5-dimethyl-4-vinylthiophenyl)sulfide, or may be bis(4-vinylthiophenyl)sulfide.

For example, in a case where the compound represented by Formula (1) is bis(4-vinylthiophenyl)sulfide in which all of $R^1$ to $R^8$ represent a hydrogen atom and n represents 0, the compound represented by Formula (1) can be obtained by a method of reacting dihaloethane with 4,4'-thiobis(benzenethiol) and then performing dehydrohalogenation on the product in a polar solvent such as dimethyl sulfoxide (ЖурналОрганической Химии, т28, вып.9 1905, 1992). In this method, by changing the reaction conditions such as the use amount and charging method of dihaloethane, it is possible to obtain vinyl sulfide compounds having different numerical values as n in Formula (1). The compound represented by Formula (1) can also be obtained by a method of reacting a mercaptan compound and a vinyl halide in the presence of a base (Japanese Unexamined Patent Publication No. H3-287572) or a method of reacting a dihalide and an aqueous solution of an alkali metal compound in an aliphatic hydrocarbon solvent in the presence of a

phase transfer catalyst (Japanese Unexamined Patent Publication No. 2003-183246A) in a heterogeneous system, the dihalide being obtained by a method of reacting a mercaptan compound and 2-halogenoethanol in the presence of an alkali metal compound and then reacting the product and a halogenating agent to produce a dihalide (Japanese Unexamined Patent Publication No. 2004-51488).

In a case where the polymerizable component includes the compound represented by Formula (1), the polymerizable component may further include other polymerizable compounds excluding the compound represented by Formula (1).

Examples of those other polymerizable compounds include a (meth)acrylic acid, a (meth)acrylic acid ester, a thio(meth)acrylic acid ester, a vinyl compound, and a sulfide compound other than the compound represented by Formula (1). From the viewpoint of improving curing properties, those other polymerizable compounds may be at least one kind of compound selected from the group consisting of a (meth)acrylic acid ester and a thio(meth)acrylic acid ester.

Examples of the (meth)acrylic acid ester include monofunctional (meth)acrylic acid esters such as methyl (meth)acrylate, ethyl (meth)acrylate, n-propyl (meth)acrylate, isopropyl (meth)acrylate, n-butyl (meth)acrylate, sec-butyl (meth)acrylate, tert-butyl (meth)acrylate, 2-methylbutyl (meth)acrylate, 2-ethylbutyl (meth)acrylate, 3-methylbutyl (meth)acrylate, 1,3-dimethylbutyl (meth)acrylate, pentyl (meth)acrylate, hexyl (meth)acrylate, cyclohexyl (meth)acrylate, 2-ethylhexyl (meth)acrylate, heptyl (meth)acrylate, octyl (meth)acrylate, 2-methoxyethyl acrylate, 2-ethoxyethyl acrylate, 3-ethoxypropyl acrylate, 2-ethoxybutyl acrylate, 3-ethoxybutyl acrylate, hydroxyethyl (meth)acrylate, hydroxypropyl (meth)acrylate, hydroxybutyl (meth)acrylate, phenyl (meth)acrylate, benzyl (meth)acrylate, phenylethyl (meth)acrylate, phenoxyethyl (meth)acrylate, (2-methyl-2-ethyl-1,3-dioxolan-4-yl) methyl (meth)acrylate, isobornyl (meth)acrylate, ethoxy o-phenylphenol (meth)acrylate, cyclic trimethylolpropane formal (meth)acrylate, tetrahydrofurfuryl (meth)acrylate, trifluoroethyl (meth)acrylate, (5-ethyl-1,3-dioxan-5-yl) methyl (meth)acrylate, glycidyl (meth)acrylate, 2-[2-hydroxy-5-[2-((meth)acryloyloxy)ethyl)phenyl]-2H-benzotriazole, 4-(meth)acryloyloxybenzophenone, phenylbenzyl (meth)acrylate, phenylthioethyl (meth)acrylates, o-phenylphenoxyethyl (meth)acrylate, naphthylthioethyl (meth)acrylate, and biphenylmethyl (meth)acrylate; and polyfunctional (meth)acrylic acid esters such as ethylene glycol di(meth) acrylate, diethylene glycol di(meth)acrylate, triethylene glycol di(meth)acrylate, tetraethylene glycol di(meth)acrylate, polyethylene glycol di(meth)acrylate, propylene glycol di(meth)acrylate, polypropylene glycol di(meth)acrylate, dipropylene glycol di(meth)acrylate, tripropylene glycol di(meth)acrylate, 1,3-butanediol di(meth)acrylate, 1,4-butanediol di(meth)acrylate, 1,5-pentanediol di(meth)acrylate, 1,6-hexanediol di(meth)acrylate, ethoxylated bisphenol A di(meth)acrylate, tricyclodecanedimethanol di(meth)acrylate, 9,9-bis[4-(2-(meth)acryloyloxyethoxy)phenyl]fluorene, trimethylolpropane tri(meth)acrylate, pentaerythritol tri(meth)acrylate, pentaerythritol tetra(meth)acrylate, dipentaerythritol penta(meth)acrylate, dipentaerythritol hexa(meth)acrylate, isocyanuric acid tri(meth)acrylate, ethoxylated isocyanuric acid tri(meth)acrylate, glycerin triacrylate, urethane-based (meth)acrylate, epoxy-based (meth)acrylate, polyester-based (meth)acrylate, polyether-based (meth)acrylate, and silicone-based (meth)acrylate.

In a case where the (meth)acrylic acid ester is a monofunctional (meth)acrylic acid ester, the monofunctional (meth)acrylic acid ester may be at least one kind of compound selected from the group consisting of methyl (meth)acrylate, ethyl (meth)acrylate, n-propyl (meth)acrylate, isopropyl (meth)acrylate, hexyl (meth)acrylate, cyclohexyl (meth)acrylate, 2-ethylhexyl (meth)acrylate, heptyl (meth)acrylate, octyl (meth)acrylate, 2-methoxyethyl acrylate, 2-ethoxyethyl acrylate, hydroxyethyl (meth)acrylate, hydroxybutyl (meth)acrylate, phenyl (meth)acrylate, benzyl (meth)acrylate, phenylethyl (meth)acrylate, phenoxyethyl (meth)acrylate, (2-methyl-2-ethyl-1,3-dioxolan-4-yl) methyl (meth)acrylate, isobornyl (meth)acrylate, ethoxy o-phenylphenol (meth)acrylate, cyclic trimethylolpropane formal (meth)acrylate, tetrahydrofurfuryl (meth)acrylate, (5-ethyl-1,3-dioxan-5-yl) methyl (meth)acrylate, glycidyl (meth)acrylate, 2-[2-hydroxy-5-[2-((meth)acryloyloxy)ethyl)phenyl]-2H-benzotriazole, phenylbenzyl (meth)acrylate, phenylthioethyl (meth)acrylate, o-phenylphenoxyethyl (meth)acrylate, naphthylthioethyl (meth)acrylate, and biphenylmethyl (meth)acrylate.

In a case where the (meth)acrylic acid ester is a polyfunctional (meth)acrylic acid ester, the polyfunctional (meth)acrylic acid ester may be at least one kind of compound selected from the group consisting of ethylene glycol di(meth)acrylate, diethylene glycol di(meth)acrylate, triethylene glycol di(meth)acrylate, tetraethylene glycol di(meth)acrylate, polyethylene glycol di(meth)acrylate, propylene glycol di(meth)acrylate, polypropylene glycol di(meth)acrylate, dipropylene glycol di(meth)acrylate, tripropylene glycol di(meth)acrylate, 1,4-butanediol di(meth)acrylate, 1,6-hexanediol di(meth)acrylate, ethoxylated bisphenol A di(meth)acrylate, tricyclodecanedimethanol di(meth)acrylate, 9, 9-bis[4-(2-(meth)acryloyloxyethoxy)phenyl] fluorene, trimethylolpropane tri(meth)acrylate, pentaerythritol tri(meth)acrylate, pentaerythritol tetra(meth)acrylate, dipentaerythritol penta(meth)acrylate, dipentaerythritol hexa(meth)acrylate, isocyanuric acid tri(meth)acrylate, and glycerin triacrylate.

Examples of the thio(meth)acrylic acid ester include are S,S'-(thiodi-p-phenylene)bis(thio(meth)acrylate), S,S' - [4,4' -thiobis(2-chlorobenzene)]bis(thio(meth)acrylate), S,S' - [4,4' -thiobis(3 - chlorobenzene)]bis(thio(meth)acrylate), S,S'-[4,4'-thiobis(2,6-dichlorobenzene)]bis(thio(meth)acrylate), S,S'-[4,4'-thiobis(3,5-dichlorobenzene)]bis(thio(meth)acrylate), S,S' -[4,4' -thiobis(2-bromobenzene)]bis(thio(meth)acrylate), S,S' - [4,4' -thiobis(3 - bromobenzene)]bis(thio(meth)acrylate), S,S' - [4,4' -thiobis(2,6-dibromobenzene)]bis(thio(meth)acrylate), S,S'-[4,4'-thiobis(3,5-dibromobenzene)]bis(thio(meth)acrylate), S,S' -[4,4' -thiobis(2-methylbenzene)]bis(thio(meth)acrylate),

S,S'-[4,4'-thiobis(3-methylbenzene)]bis(thio(meth)acrylate), S,S'-[4,4'-thiobis(2,6-dimethylbenzene)]bis(thio(meth)acrylate), S,S'-[4,4'-thiobis(3,5-dimethylbenzene)]bis(thio(meth)acrylate), S,S'-[4,4'-thiobis(2-tert-butylbenzene)]bis(thio(meth)acrylate), S,S'-(thiodiethylene)bis(thio(meth)acrylate), S,S'-ethylenebis(thio(meth)acrylate), S,S'-[thiobis(diethylenesulfide)]bis(thio(meth)acrylate), S,S'-(oxydiethylene)bis(thio(meth)acrylate), phenylthio(meth)acrylate, 1,4-benzene dithio(meth)acrylate, 4-methylbenzene thio(meth)acrylate, 2-methylbenzene thio(meth)acrylate, 4,4'-di(meth)acryloyl thiobiphenyl, 2-naphthalene thio(meth)acrylate, 2-pyridine thio(meth)acrylate, 4-pyridine thio(meth)acrylate, 2-thiophene thio(meth)acrylate, and 1,3,5-triazine-2,4,6-trithio(meth)acrylate.

The thio(meth)acrylic acid ester may be at least one kind of compound selected from the group consisting of S,S'-(thiodi-p-phenylene)bis(thio(meth)acrylate), S,S' - [4,4' -thiobis(3,5-dibromobenzene)]bis(thio(meth)acrylate), S,S' - [4,4' -thiobis(3,5-dimethylbenzene)]bis(thio(meth)acrylate), and S,S'-(thiodiethylene)bis(thio(meth)acrylate), or may be S,S'-(thiodi-p-phenylene)bis(thio(meth)acrylate).

Examples of the vinyl compound include monofunctional vinyl compounds such as styrene, α-methylstyrene, 2,4-dimethylstyrene, α-ethylstyrene, α-butylstyrene, α-hexylstyrene, 4-chlorostyrene, 3-chlorostyrene, 4-bromostyrene, 4-nitrostyrene, 4-methoxystyrene, vinyltoluene, and cyclohexene; and polyfunctional vinyl compounds such as divinylbenzene, 4-vinylcyclohexene, 5-vinylbicyclo[2,2,1]hept-2-ene, diallyl diphenate, and triallyl triazine.

The vinyl compound may be at least one kind of compound selected from the group consisting of styrene, vinyltoluene, cyclohexene, divinylbenzene, 5-vinylbicyclo[2,2,1]hept-2-ene, diallyl diphenate, and triallyl triazine, or may be styrene, divinylbenzene, or a combination of these.

Examples of sulfide compounds other than the compound represented by Formula (1) include methyl vinyl sulfide, ethyl vinyl sulfide, n-propyl vinyl sulfide, isobutyl vinyl sulfide, tert-butyl vinyl sulfide, n-amyl vinyl sulfide, isoamyl vinyl sulfide, cyclohexyl vinyl sulfide, 2-ethylhexyl vinyl sulfide, n-octadecyl vinyl sulfide, dodecyl vinyl sulfide, phenyl vinyl sulfide, propenyl sulfide propylene carbonate, ethylene glycol monovinyl sulfide, ethylene glycol divinyl sulfide, diethylene glycol monovinyl sulfide, diethylene glycol divinyl sulfide, triethylene glycol monovinyl sulfide, triethylene glycol divinyl sulfide, butanediol monovinyl sulfide, butanediol divinyl sulfide, hexanediol monovinyl sulfide, hexanediol divinyl sulfide, cyclohexanedimethanol monovinyl sulfide, and cyclohexanedimethanol divinyl sulfide.

In the above embodiment, from the viewpoint of making it easy to well form a pattern on the resin layer while increasing the refractive index of the cured material, the content of the compound represented by Formula (1) may be 50% by mass or more, 55% by mass or more, 60% by mass or more, 70% by mass or more, or 80% by mass or more, based on the total amount of the polymerizable component. The content of the compound represented by Formula (1) may be 99.95% by mass or less or 99.90% by mass or less, based on the total amount of the polymerizable component.

In the above embodiment, from the viewpoint of increasing the refractive index of the cured material, the content of other polymerizable compounds excluding the compound represented by Formula (1) may be 50% by mass or less, 45% by mass or less, or 20% by mass or less, based on the total amount of the polymerizable component.

From the viewpoint of making it easy to well form a pattern on the resin layer while increasing the refractive index of the cured material, the content of the organic sulfur compound may be 50% by mass or more, 60% by mass or more, 70% by mass or more, or 80% by mass or more, based on the total amount of the polymerizable component. The content of the organic sulfur compound may be 99.95% by mass or less or 99.90% by mass or less, based on the total amount of the polymerizable component. In a case where the polymerizable component includes the compound represented by Formula (1) and other polymerizable compounds excluding the compound represented by Formula (1), and some or all of those other polymerizable compounds are organic sulfur compounds (for example, thio(meth)acrylic acid esters or sulfide compounds other than the compound represented by Formula (1)), the content of the organic sulfur compounds is the sum of the content of the compound represented by Formula (1) and the content of the organic sulfur compounds as other polymerizable compounds excluding the compound represented by Formula (1).

From the viewpoint of further increasing the refractive index of the cured material, the refractive index nD of the organic sulfur compound at a wavelength of 589 nm at 25°C may be 1.67 or more, 1.68 or more, or 1.69 or more. The refractive index nD of the organic sulfur compound in the present specification is a value measured at 25°C with a multi-wavelength Abbe refractometer (for example, manufactured by ATAGO CO., LTD., model number: DR-M4) by using a 589 nm interference filter.

From the viewpoint of making it easy to form a good pattern on the resin layer, the viscosity of the organic sulfur compound at 25°C may be less than 30 mPa·s, 25 mPa·s or less, or 20 mPa·s or less. The viscosity of the organic sulfur compound in the present specification is viscosity measured at 25°C by using an E-type viscometer (for example, TVE-25H manufactured by TOKI SANGYO CO., LTD.: based on ISO 3219, JIS K 7117-2: 1999, and JIS Z8803: 2011).

The photosensitive resin composition may further contain a radical polymerization initiator. The radical polymerization initiator may be a photoradical polymerization initiator.

Examples of the photoradical polymerization initiator include benzoin compounds, such as benzoin, benzoin methyl ether, benzoin ethyl ether, and benzoin isopropyl ether, and alkyl ether compounds thereof; alkylphenone compounds such as 2,2-dimethoxy-2-phenylacetophenone, 1-hydroxycyclohexyl phenyl ketone, 2-hydroxy-2-methyl propiophenone, 2-hydroxy-4'-(2-hydroxyethoxy)-2-methyl propiophenone, 1,1' -(methylene-di-4,1 -phenylene)bis [2-hydroxy-2-methyl-1-propanone] 2-methyl-4' -(methylthio)-2-morpholinopropiophenone, and 2-benzyl-2-(dimethylamino)-4'-morpholinobutyrophenone; acylphosphine oxide compounds such as 2,4,6-trimethylbenzoyl-diphenylphosphine oxide and bis(2,4,6-trimethylbenzoyl)phenylphosphine oxide; intramolecular hydrogen abstraction-type compounds such as methyl benzoylformate; and oxime ester compounds such as 1-[4-(phenylthio)phenyl]octane-1,2-dione=2-(o-benzoyloxime) and 1-[9-ethyl-6-(2-methylbenzoyl)-9H-carbazol-3-yl]etanone=1-(o-acetyloxime). One kind of each of these photoradical polymerization initiators can be used alone, or two or more kinds of these photoradical polymerization initiators can be used in combination.

The photoradical polymerization initiator may include an alkylphenone compound, an acylphosphine oxide compound, or a combination of these.

From the viewpoint of allowing curing of the photosensitive resin composition to thoroughly advance, the content of the radical polymerization initiator with respect to 100 parts by mass of the polymerizable component may be 0.1 parts by mass or more or 0.5 parts by mass or more. From the viewpoint of preventing an increase in yellowness of the cured material, the content of the radical polymerization initiator with respect to 100 parts by mass of the polymerizable component may be 7 parts by mass or less, 5 parts by mass or less, or 4 parts by mass or less.

If necessary, the photosensitive resin composition according to the present embodiment may further contain other components. Examples thereof include additives such as an organic solvent, a polymerization inhibitor, an antioxidant, a light stabilizer, a plasticizer, a leveling agent, a defoaming agent, an ultraviolet absorber, a coupling agent, a sensitizer, a metal deactivator, a chain transfer agent, an antiblocking agent, a photocationic polymerization initiator, a thermal cationic polymerization initiator, inorganic fine particles, and a release agent. The content of these additives can be appropriately set within a range that does not significantly impair the effects of the present invention. Usually, the content of the additives with respect to 100 parts by mass of the polymerizable component in the photosensitive resin composition may be 30 parts by mass or less, 20 parts by mass or less, or 10 parts by mass or less.

The photosensitive resin composition according to an embodiment can be produced by a method of mixing together the aforementioned components and stirring the mixture. These components may be mixed together simultaneously or sequentially. The temperature of the photosensitive resin composition (mixture) at the time of stirring is not particularly limited, but may be 0°C to 100°C or 10°C to 80°C. The stirring time may be 1 minute to 24 hours, or 1 minute to 6 hours. In a case where the photosensitive resin composition contains a radical polymerization initiator, the temperature during stirring and the stirring time may be appropriately adjusted depending on the type of the polymerization initiator.

From the viewpoint of forming a good pattern on the resin layer, the viscosity of the photosensitive resin composition at 25°C may be less than 20 mPa·s. From the same viewpoint, the viscosity of the photosensitive resin composition may be 19 mPa·s or less or 18 mPa·s or less. From the viewpoint of preventing dripping from the die, the viscosity of the photosensitive resin composition may be 1.0 mPa·s or more or 5.0 mPa·s or more. The viscosity of the photosensitive resin composition can be measured by the method described above. The viscosity of the photosensitive resin composition can be adjusted, for example, by the type and content of the organic sulfur compound.

The refractive index nD of the photosensitive resin composition at a wavelength of 589 nm at 25°C may be 1.65 or more, 1.66 or more, or 1.67 or more. The refractive index nD of the photosensitive resin composition can be measured by the method described above. The refractive index nD of the photosensitive resin composition can be adjusted, for example, by the type and content of the organic sulfur compound.

In the photosensitive resin composition, the refractive index nD that the cured material formed by curing the photosensitive resin composition has at a wavelength of 589 nm at 25°C may be 1.67 or more, 1.68 or more, 1.69 or more, 1.70 or more, 1.71 or more, or 1.72 or more. The refractive index nD of the cured material is a refractive index determined by curing the photosensitive resin composition under the conditions described in Examples which will be described later so that a cured material having a thickness of 90 to 110 μm is obtained, and measuring the refractive index of the cured material with a multi-wavelength Abbe refractometer by using a 589 nm interference filter at 25°C.

Regarding the photosensitive resin composition, a cure shrinkage rate of the cured material formed by curing the photosensitive resin composition may be less than 10%. In a case where the cure shrinkage rate is in this range, it is possible to prevent the pattern formed on the resin layer from being deformed after curing. The cure shrinkage rate may be 8% or less, 7% or less, or 5% or less. The cure shrinkage rate of the cured material can be determined by measuring the density of the photosensitive resin composition not yet being cured by the method described in JIS K 0061: 2001, measuring the density of the cured material by the method described in JIS K 7112: 1999, and calculating a difference between the densities.

<Molded Article that is Provided with Pattern and Method for Producing the Molded Article>

A molded article that is provided with a pattern can be produced by an imprint method by using the aforementioned photosensitive resin composition. The method for producing the molded article that is provided with a pattern includes forming a reverse pattern of a pattern of a mold on a resin layer by using the mold having the pattern and irradiating the resin layer with light. The resin layer contains the aforementioned photosensitive resin composition.

Fig. 1 is a schematic cross-sectional view showing an embodiment of a method for producing a molded article that is provided with a pattern. In this production method, first, a mold 11 having a pattern is prepared (Fig. 1(a)). The pattern is, for example, an uneven pattern as shown in Fig. 1, but the pattern shape is not limited. As the mold 11, it is possible to appropriately use a mold usually used in the conventional imprint method. For example, the mold 11 may be formed of silicon, quartz, a metal, or the like.

In the mold 11, in order to enable the resin (cured material) to be well released from the mold after molding, a surface 11a provided with a pattern may be treated with a release agent. The release agent may be a silane coupling agent such as perfluoropolyalkylmethylsiloxane, for example, AquaphobeCF (manufactured by Gelest) or Optool-DSX (manufactured by DAIKIN INDUSTRIES, Ltd.) which are commercially available products.

Subsequently, in the mold 11, the photosensitive resin composition is placed on the surface 11a provided with a pattern, so that the pattern in the mold 11 is filled with the photosensitive resin composition (Fig. 1(b)). In this way, it is possible to obtain a resin layer 1 provided with a reverse pattern of the pattern of the mold 11. The method of filling the pattern in the mold 11 with the photosensitive resin composition is not particularly limited, and a conventionally used method can be appropriately used. As shown in Fig. 1(b), the resin layer 1 may be provided to cover projections of the pattern of the mold 11 or provided to fill up only recesses of the pattern of the mold 11.

The thickness of the resin layer 1 can be appropriately set depending on the desired molded article. For example, the thickness of the thickest site of the resin layer 1 may be 0.1 $\mu$m to 1 mm or 1 $\mu$m to 50 $\mu$m.

The photosensitive resin composition may be subjected to a treatment, such as degassing or defoaming, before being placed on the mold 11. In a case where the photosensitive resin composition is subjected to such a treatment, dissolved oxygen and air bubbles in the photosensitive resin composition can be removed, which enables curing (polymerization) of the photosensitive resin composition to efficiently advance. Furthermore, it is possible to prevent air bubbles from being mixed into the cured material of the photosensitive resin composition. The method of degassing or defoaming the photosensitive resin composition is not particularly limited. For example, it is possible to adopt bubbling with an inert gas such as nitrogen and argon, vacuum degassing under reduced pressure, ultrasonic degassing, hollow fiber membrane degassing, or a combination of these.

Then, a substrate 12 is placed to come into contact with a surface 1a of the resin layer 1 opposite to the mold 11 (Fig. 1(c)). As the substrate 12, it is possible to appropriately use a mold usually used in the conventional imprint method. For example, the substrate 12 may be formed of glass, a transparent resin, or silicon.

For a hydrophobic treatment, the substrate 12 may be placed on the resin layer 1 via a coating substrate (not shown in the drawing) formed of hexamethyldisilazane (HMDS) or the like. Furthermore, in order to impart stronger adhesiveness to the substrate 12, the surface of the substrate 12 may be treated with, for example, oxygen plasma or the like.

Thereafter, the resin layer 1 is irradiated with light, from the surface of the substrate 12 opposite to the surface on which the resin layer 1 is provided (Fig. 1(d)). By the irradiation with light, the photosensitive resin composition is cured, and a cured material 2 is obtained. Curing of the photosensitive resin composition may advance by radical polymerization (photo-radical polymerization). In a case where the substrate 12 is a light transmitting substrate formed of glass or the like, the light irradiation may be performed as described above. In a case where the substrate 12 is a substrate that is formed of silicon or the like and does not transmit light, quartz or the like may be used for the mold 11, and the resin layer 1 may be irradiated with light, from the surface of the mold 11 opposite to the surface on which the resin layer 1 is provided.

The type of light to be radiated may be light rays such as ultraviolet rays (UV) or visible rays. Examples of the light source include a low-pressure mercury lamp, a high-pressure mercury lamp, an ultrahigh-pressure mercury lamp, a metal halide lamp, a deuterium lamp, an argon lamp, a xenon lamp, LED, a halogen lamp, an excimer laser, and a helium-cadmium laser. The light source may be a high-pressure mercury lamp, a metal halide lamp, a xenon lamp, or LED, or may be a high-pressure mercury lamp or LED.

In a case where the light is UV, the intensity of UV to be radiated may be 5 to 1,000 $mW/cm^2$, 10 to 700 $mW/cm^2$, or 20 to 500 $mW/cm^2$ as a value measured using an integrating UV radiometer, UVM-100 ($\lambda$ = 300 to 450 nm) manufactured by AITEC SYSTEM Co., Ltd. In a case where the UV intensity is 5 $mW/cm^2$ or more, curing defects can be prevented, and the refractive index of the cured material 2 can be particularly increased, which makes it possible to increase elastic modulus and Tg as well. In a case where the UV intensity is 1,000 $mW/cm^2$ or less, coloring of the cured material 2 can be prevented.

The light irradiation time is usually 5 seconds to 20 minutes, and may be 10 seconds to 15 minutes or 15 seconds to 10 minutes. In a case where the light irradiation time is 5 seconds or more, curing defects can be prevented, and the refractive index of the cured material 2 can be particularly increased, which makes it possible to increase elastic modulus and Tg as well. In a case where the light irradiation time is 20 minutes or less, coloring of the cured material 2 can be prevented.

In a case where the light is UV, the integrated light quantity of the radiated light (UV) is a value obtained by dividing the product ($mJ/cm^2$) of the aforementioned UV intensity ($mW/cm^2$) and UV irradiation time (seconds) by 1,000

(J/cm$^2$). The integrated light quantity may be 0.1 to 100 J/cm$^2$ or 1 to 50 J/cm$^2$. In a case where the integrated light quantity of UV is 0.1 J/cm$^2$ or more, curing defects can be prevented, and the refractive index of the cured material 2 can be particularly increased, which makes it possible to increase elastic modulus and Tg as well. In a case where the integrated light quantity of UV is 100 J/cm$^2$ or less, coloring of the cured material 2 can be prevented.

Thereafter, the mold 11 having a pattern is removed from the cured material 2 of the photosensitive resin composition (Fig. 1(e)). In this way, it is possible to obtain a molded article 10 having the substrate 12 and the cured material 2 provided with a reverse pattern of the pattern of the mold 11. After removal of the mold 11, the cured material 2 may be further cured by being irradiated with light again.

Fig. 2 is a schematic cross-sectional view showing another embodiment of the method for producing a molded article that is provided with a pattern. The configurations or parts corresponding to the respective configurations in Fig. 1 are assigned with the same reference numerals, and will not be described again.

In this production method, first, the substrate 12 is prepared, and the aforementioned photosensitive resin composition is placed on one surface 12a of the substrate 12 (Fig. 2(a)). In this way, the resin layer 1 provided on one surface 12a of the substrate 12 can be obtained. The thickness of the resin layer 1 may be in the same range as the thickness in the first embodiment.

Subsequently, the mold 11 having a pattern is prepared, and the surface of the mold 11 provided with the pattern is pressed on the resin layer 1 (Figs. 2(b) and 2(c)). The method of pressing the mold 11 on the resin layer 1 is not particularly limited, and may be a method of manually pressing the mold, a method of using a device such as a press device, or the like. Pressing the mold 11 on the resin layer 1 enables the pattern on the mold 11 to be filled with the photosensitive resin composition, which leads to the formation of a reverse pattern of the pattern of the mold 11 on the resin layer 1.

Then, the resin layer 1 is irradiated with light, from the surface of the substrate 12 opposite to the surface on which the resin layer 1 is provided (Fig. 2(d)). The light irradiation method and light irradiation conditions are the same as the method and conditions in the first embodiment described above. In this way, the photosensitive resin composition is cured, and the cured material 2 is obtained.

Thereafter, the mold 11 having a pattern is removed from the cured material 2 of the photosensitive resin composition (Fig. 2(e)). In this way, it is possible to obtain a molded article 10 having the substrate 12 and the cured material 2 provided with a reverse pattern of the pattern of the mold 11.

In the production method according to each of the embodiments described above, the aforementioned photosensitive resin composition is used as the resin layer 1. Therefore, it is easy to fill the pattern of the mold 11 having a pattern without gaps. Therefore, on the resin layer 1, a reverse pattern of the pattern of the mold 11 can be well formed, in other words, formed with high accuracy. The photosensitive resin composition is unlikely to shrink or crack after curing. Accordingly, even after the resin layer 1 having undergone pattern formation is cured, it is possible to prevent the deformation or collapse of the pattern formed on the cured material 2 in the molded article 10.

[Examples]

Hereinafter, the present invention will be more specifically described based on examples. However, the present invention is not limited to the following examples.

1. Preparation of Raw material

[Production Example 1]

<Compound (A-1): Production of Bis(4-vinylthiophenyl)sulfide>

4,4'-Thiobis(benzenethiol) (250.4 g, 1.0 mol) and 480.0 g (2.0 mol) of a 17% by mass aqueous sodium hydroxide solution were put in a 4-neck flask having a volume of 2 L and equipped with a stirrer, a dropping funnel, and a thermometer, and stirred at 60°C for 1 hour. Then, 169.1 g (2.1 mol) of 2-chloroethanol was added dropwise for 1.5 hours to the solution kept at 60°C. After the dropwise addition finished, the solution was stirred at 60°C for 1.5 hours. After the reaction finished, the reaction solution was cooled to 20°C, the precipitated crystals were separated by filtration, and the obtained crystals were washed twice with 400 g of water, thereby obtaining 492.5 g of a wet cake of bis[4-(2-hydroxyethylthio)phenyl]sulfide.

The obtained wet cake of bis[4-(2-hydroxyethylthio)phenyl]sulfide (492.5 g) and 1,500 g of toluene were put in a 4-neck flask having a volume of 3 L and equipped with a stirrer, a dropping funnel, and a thermometer, and the mixed liquid was heated at 110°C so that water was distilled off. During the distillation, toluene distilled off together with water by azeotropy was separated from water and returned to the flask. Then, the mixed liquid having undergone distillation was cooled to 70°C. Thionyl chloride (249.9 g, 2.1 mol) was added dropwise for 2 hours to the mixed liquid kept at 70°C

after being cooled. After the dropwise addition finished, the mixed liquid was stirred at 70°C for 2 hours. After the reaction finished, 600 g (1.5 mol) of a 10% by mass aqueous sodium hydroxide solution was added to the obtained reaction solution, and liquid separation was performed at 70°C. The organic layer obtained by the liquid separation was cooled to 10°C, and the precipitated crystals were filtered. The obtained crystals were washed with 600 g of n-heptane and dried at 50°C under reduced pressure, thereby obtaining 348.0 g (0.93 mol) of bis[4-(2-chloroethylthio)phenyl]sulfide.

Then, 348.0 g (0.93 mol) of bis[4-(2-chloroethylthio)phenyl]sulfide, 780 g of n-heptane, 14.9 g (0.046 mol) of tetrabutylammonium bromide, and 232.5 g (2.8 mol) of a 48% by mass aqueous sodium hydroxide solution were put in a 4-neck flask having a volume of 3 L and equipped with a stirrer and a thermometer, and stirred at 75°C to 85°C for 5.5 hours. After the reaction finished, 428 g of water was added to the reaction solution in the flask, and liquid separation was performed on the mixed liquid at 60°C. The organic layer obtained by the liquid separation was further washed twice with 372 g of water, thereby obtaining 1,050 g of a n-heptane solution of bis(4-vinylthiophenyl)sulfide.

2,6-Di-tert-butyl-4-methylphenol (1.4 g) was added to the obtained n-heptane solution, and n-heptane was distilled off under the conditions of 0.6 kPa and 40°C, thereby obtaining 275.3 g (0.91 mol) of bis(4-vinylthiophenyl)sulfide. The HPLC purity of the obtained bis(4-vinylthiophenyl)sulfide was 99.3%. The yield to 4,4'-thiobis(benzenethiol) was 91%.

The refractive index and viscosity of the obtained bis(4-vinylthiophenyl)sulfide (A-1) were measured by the measurement method that will be described later. The refractive index nD (589 nm) at 25°C was 1.69, and the viscosity at 25°C was 16 mPa·s.

[Production Example 2]

<Compound (A-2): Production of Bis(2,3-epithiopropyl)sulfide>

Bis(2,3-epoxypropyl)sulfide (365.0 g, 2.5 mol), 761.2 g (10.0 mol) of thiourea, and 43.8 g (0.43 mol) of acetic anhydride were sequentially injected into a flask equipped with a stirrer, a thermometer, and a nitrogen introduction tube. Furthermore, as solvents, 3.4 L of methanol and 1.7 L of toluene were injected into the flask, and the compounds and the solvents were reacted at 20°C for 10 hours in a nitrogen atmosphere while being stirred. After the reaction, the reaction product was extracted using 4.3 L of toluene, washed with 520 ml of 10% by mass sulfuric acid, and further washed 4 times with 520 ml of water, thereby obtaining an organic layer. The solvent was distilled off from the obtained organic layer at 40°C under a pressure reduced to 1 kPa, thereby obtaining 338.8 g of bis(2,3-epithiopropyl)sulfide (yield of 76% to bis(2,3-epoxypropyl)sulfide). The HPLC purity of the obtained bis(2,3-epithiopropyl)sulfide was 99.0%.

The refractive index and viscosity of the obtained bis(2,3-epithiopropyl)sulfide (A-2) were measured by the measurement method that will be described later. The refractive index nD (589 nm) at 25°C was 1.65, and the viscosity at 25°C was 12 mPa·s.

For preparing the photosensitive resin composition, as components other than the above, the following components were used.

Compound (B-1): (5-ethyl-1,3-dioxan-5-yl)methyl acrylate ("VISCOAT 200" manufactured by OSAKA ORGANIC CHEMICAL INDUSTRY LTD.)

Compound (B-2): ethoxylated bisphenol A dimethacrylate ("BPE-80N" manufactured by SHIN-NAKAMURA CHEMICAL CO, LTD.)

Compound (B-3): pentaerythritol tetrakis(3-mercaptopropionate)

Compound (C-1): 2-hydroxy-2-methyl propiophenone ("Omnirad 1173" manufactured by IGM Resins)

Compound (C-2): bis(2,4,6-trimethylbenzoyl)phenylphosphine oxide ("Omnirad 819" manufactured by IGM Resins)

Compound (C-3): guanidinium 2-(3-benzoylphenyl)propionate (manufactured by FUJIFILM Wako Chemical Corporation)

2. Preparation of Photosensitive Resin Composition and Cured Material

(Example 1)

The compound (A-1) and the compound (C-1) were mixed together at the mass ratio shown in Table 1 and stirred at 25°C for 30 minutes, and then the obtained mixture was degassed under reduced pressure in a vacuum at 25°C for 10 minutes, thereby obtaining a photosensitive resin composition. Then, a gap of a glass mold formed of two sheets of glass plates (manufactured by Matsunami Glass Ind., Ltd., model number: S9224) was filled with the photosensitive resin composition, the glass plates each having a thickness of 1.2 mm and a size of 76 x 52 mm and arranged to face each other so that a 100 μm gap is formed therebetween. By using an LED lamp (wavelength: 365 nm), the photosensitive resin composition with which the glass mold was filled was irradiated with light (UV) from one glass surface side, thereby curing the photosensitive resin composition. As conditions of the UV curing, the UV intensity was

set to 200 mW/cm$^2$, the irradiation time was set to 2 minutes, and the irradiation dose was set to 24 J/cm$^2$. The cured material was released from the glass mold, thereby obtaining a molded material for evaluation having a thickness of about 100 $\mu$m.

(Examples 2 and 3 and Comparative Example 1)

According to the composition shown in Table 1, a photosensitive resin composition was prepared by the same method as in Example 1 and cured, thereby preparing a molded material for evaluation as a cured material.

3. Physical Properties of Photosensitive Resin Composition and Cured Material (Molded Material for Evaluation)

The following physical properties were measured using the prepared molded material for evaluation. The results are shown in Table 1.

<Thickness>

The thickness of the obtained molded material for evaluation was measured using a micrometer (manufactured by Mitutoyo Corporation, model number: MDC-25MX).

<Refractive index nD>

For the photosensitive resin composition and the obtained molded material for evaluation, the refractive index nD at 25°C was measured with a multi-wavelength Abbe refractometer (manufactured by ATAGO CO., LTD., model number: DR-M4) using a 589 nm interference filter.

<Viscosity>

By using an E-type viscometer (manufactured by TOKI SANGYO CO., LTD., model number: TVE-25H, based on ISO 3219, JIS K 7117-2: 1999, and JIS Z8803: 2011), the viscosity was measured at 25°C.

<Cure Shrinkage Rate>

The cure shrinkage rate was determined by measuring the density of the photosensitive resin composition not yet being cured by the method described in JIS K 0061: 2001, measuring the density of the cured material by the method described in JIS K 7112: 1999, and calculating a difference between the densities. Specifically, a density $\rho 0$ of the photosensitive resin composition not yet being cured was calculated from the volume and weight of the composition measured at 23°C, and a density $\rho 1$ of the cured resin having undergone curing was determined by being measured in water based on JIS K7112. From these densities, the cure shrinkage rate was calculated from Formula (a) based on JIS K7147.

$$\text{Cure shrinkage rate (\%)} = (\rho 1 - \rho 0) \times 100/\rho 0 \quad \text{(a)}$$

<Evaluation of Imprinted Molded Article>

A 4-inch glass wafer having undergone a surface treatment with oxygen plasma was coated with the obtained photosensitive resin composition, thereby forming a resin layer. A silicon die for nanoimprint (manufactured by KYODO INTERNATIONAL, INC., 150 nm pitch L & S mold) having a pattern was placed on the resin layer so that the maximum thickness of the resin layer was 10 $\mu$m, and the die was pressed on the resin layer. By using an LED lamp (wavelength: 365 nm), the photosensitive resin composition with which the die was filled was irradiated with light (UV) from the glass wafer side under the conditions of the UV intensity of 200 mW/cm$^2$, the irradiation time of 2 minutes, and the irradiation dose of 24 J/cm$^2$, thereby curing the photosensitive resin composition. The cured material was released from the die, thereby preparing a molded article including a cured material to which 150-nm pitch L & S arrays as a reverse pattern of the pattern of the die were transferred. The surface structure of the pattern formed on the cured material was observed with a scanning electron microscope (SEM). A cured material to which the pattern of the die was accurately transferred without missing of the transferred shape was graded A, and a cured material to which the pattern of the die was not accurately transferred (for example, a cured material found to have missing or cracking of the pattern) was graded B. In this way, whether or not the photosensitive resin composition is adaptable to the imprint method was evaluated. The

results are shown in Table 1.

[Table 1]

| | | | Example | | | Comparative Example |
|---|---|---|---|---|---|---|
| | | | 1 | 2 | 3 | 1 |
| Composition (% by mass) | Polymerizable component | A-1 | 98 | 88 | 88 | - |
| | | A-2 | - | - | - | 84 |
| | | B-1 | - | 10 | - | - |
| | | B-2 | - | - | 10 | - |
| | | B-3 | - | - | - | 14 |
| | Radical polymerization initiator | C-1 | 2 | 2 | - | - |
| | | C-2 | - | - | 2 | - |
| | | C-3 | - | - | - | 2 |
| Physical properties of photosensitive resin composition | | Viscosity [mPa·s] | 16 | 18 | 19 | 20 |
| | | Refractive index nD (589 nm) | 1.69 | 1.67 | 1.67 | 1.64 |
| Physical properties of cured material | | Thickness [μm] | 10 | 10 | 10 | 10 |
| | | Refractive index nD (589 nm) | 1.73 | 1.71 | 1.71 | 1.69 |
| | | Cure shrinkage rate [%] | 8 | 7 | 3 | 12 |
| Evaluation of imprinted molded article | | | A | A | A | B |

**Reference Signs List**

1...Resin layer, 2...Cured material of photosensitive resin composition, 10...Molded article provided with pattern, 11...Mold having pattern, 12...Substrate.

**Claims**

1. A photosensitive resin composition comprising:

   a polymerizable component,
   wherein the photosensitive resin composition is used to form a resin layer in an imprint method including forming a reverse pattern of a pattern of a mold on a resin layer by using the mold having the pattern,
   wherein the polymerizable component contains an organic sulfur compound, and
   a viscosity of the photosensitive resin composition at 25°C is less than 20 mPa·s.

2. The photosensitive resin composition according to claim 1, wherein a refractive index nD of the photosensitive resin composition at a wavelength of 589 nm at 25°C is 1.65 or more.

3. The photosensitive resin composition according to claim 1 or 2, wherein a refractive index nD of the organic sulfur compound at a wavelength of 589 nm at 25°C is 1.67 or more, and a viscosity of the organic sulfur compound at 25°C is less than 30 mPa·s.

4. The photosensitive resin composition according to any one of claims 1 to 3, wherein the organic sulfur compound includes a compound represented by Formula (1),

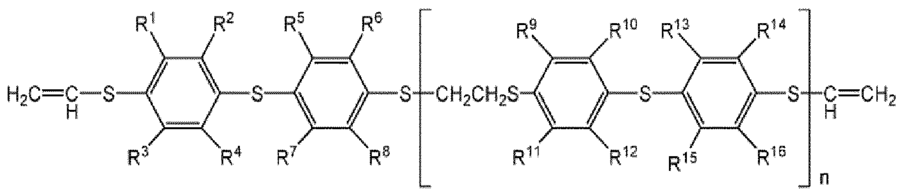

(1)

in Formula (1), $R^1$, $R^2$, $R^3$, $R^4$, $R^5$, $R^6$, $R^7$, $R^8$, $R^9$, $R^{10}$, $R^{11}$, $R^{12}$, $R^{13}$, $R^{14}$, $R^{15}$, and $R^{16}$ may be the same as or different from each other and each represent a hydrogen atom, a halogen atom, or an alkyl group having 1 to 6 carbon atoms, and n represents an integer of 0 to 10.

**5.** The photosensitive resin composition according to claim 4, wherein the polymerizable component further contains other polymerizable compounds excluding the compound represented by Formula (1).

**6.** The photosensitive resin composition according to claim 5, wherein the other polymerizable compounds include at least one selected from the group consisting of a (meth)acrylic acid ester and a thio(meth)acrylic acid ester.

**7.** The photosensitive resin composition according to any one of claims 1 to 6, wherein a content of the organic sulfur compound is 50% by mass or more based on a total amount of the polymerizable component.

**8.** The photosensitive resin composition according to any one of claims 1 to 7, further comprising a radical polymerization initiator.

**9.** The photosensitive resin composition according to any one of claims 1 to 8, wherein a refractive index nD of a cured material formed by curing the photosensitive resin composition has at a wavelength of 589 nm at 25°C is 1.70 or more.

**10.** The photosensitive resin composition according to any one of claims 1 to 9, wherein a cure shrinkage rate of a cured material formed by curing the photosensitive resin composition is less than 10%.

**11.** A molded article that is provided with a pattern, the molded article comprising: a cured material formed by curing the photosensitive resin composition according to any one of claims 1 to 10.

**12.** A method for producing a molded article that is provided with a pattern, the method comprising:

forming a reverse pattern of a pattern of a mold on a resin layer by using the mold having the pattern; and irradiating the resin layer with light,
wherein the resin layer contains the photosensitive resin composition according to any one of claims 1 to 10.

*Fig.1*

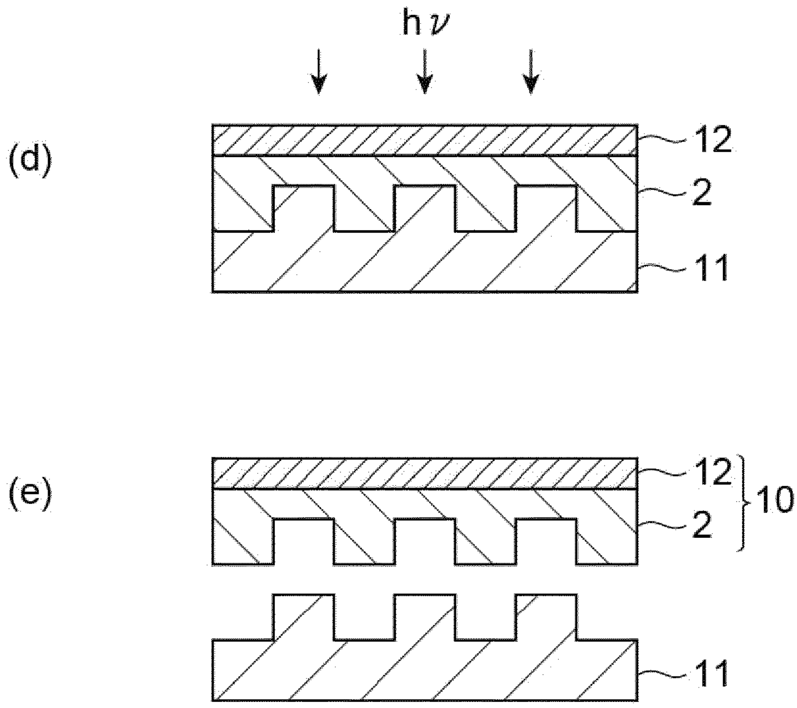

Fig.2

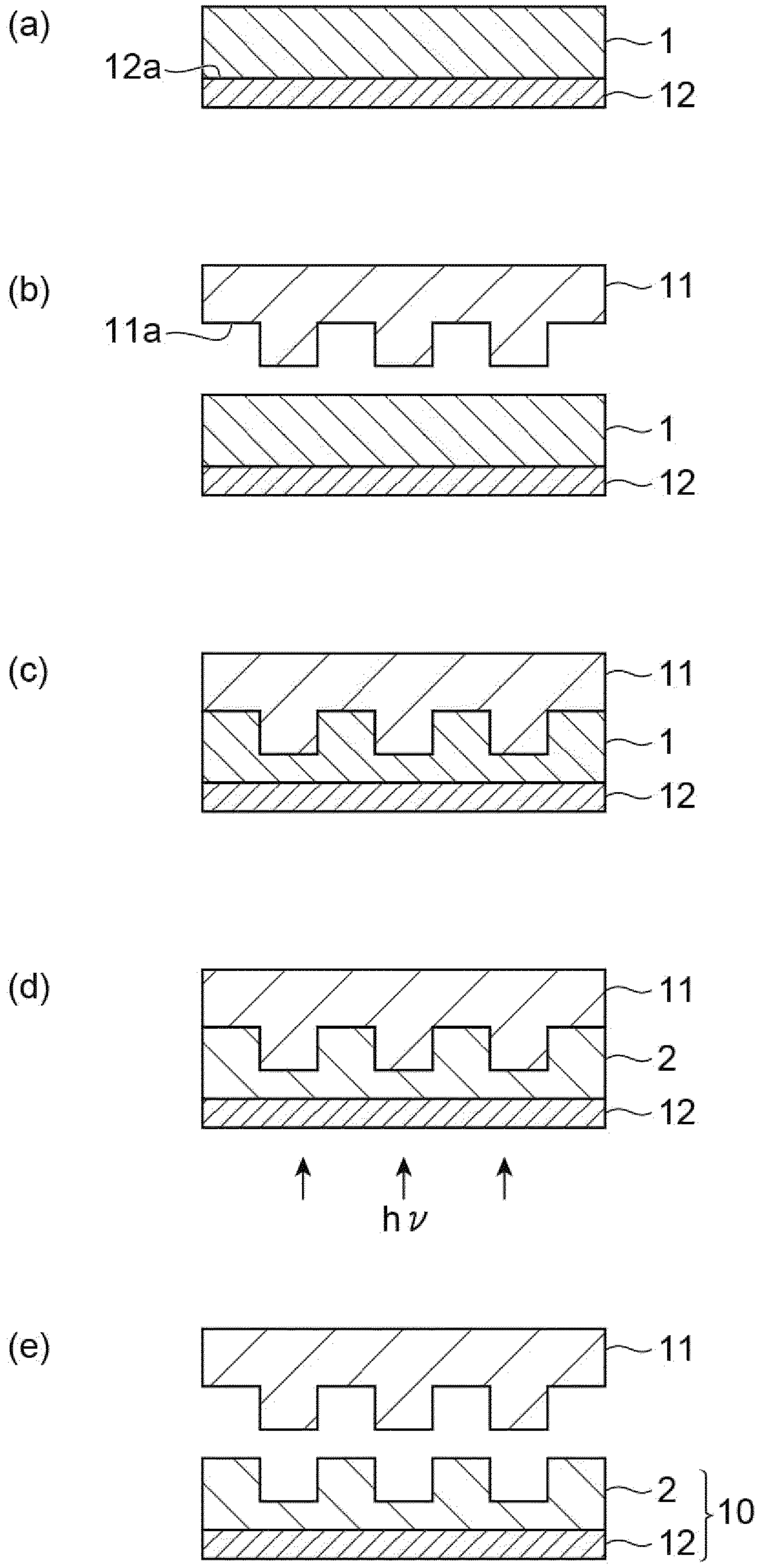

## INTERNATIONAL SEARCH REPORT

International application No. PCT/JP2021/008009

A. CLASSIFICATION OF SUBJECT MATTER
Int.Cl. C08F290/06(2006.01)i, C08F228/04(2006.01)i, H01L21/027(2006.01)i
FI: H01L21/30502D, C08F228/04, C08F290/06

According to International Patent Classification (IPC) or to both national classification and IPC

B. FIELDS SEARCHED

Minimum documentation searched (classification system followed by classification symbols)
Int.Cl. C08F290/06, C08F228/04, H01L21/027

Documentation searched other than minimum documentation to the extent that such documents are included in the fields searched

| | |
|---|---|
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2011-187824 A (FUJIFILM CORPORATION) 22 September 2011 (2011-09-22), claims 1, 5, paragraphs [0017], [0042]-[0044], [0048], [0082]-[0086] | 1, 4-8, 11-12 |
| Y | claims 1, 5, paragraphs [0017], [0042]-[0044], [0082]-[0086] | 2-3, 9 |
| Y | JP 2013-124338 A (KANSAI UNIV) 24 June 2013 (2013-06-24), claim 1, paragraphs [0102]-[0110] | 2-3, 9 |
| A | WO 2018/155013 A1 (NISSAN CHEMICAL CORPORATION) 30 August 2018 (2018-08-30), paragraphs [0019]-[0075] | 1-12 |
| A | JP 2014-82469 A (FUJIFILM CORPORATION) 08 May 2014 (2014-05-08), claim 1, paragraphs [0100]-[0122] | 1-12 |

☒ Further documents are listed in the continuation of Box C.  ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 21 April 2021 | 18 May 2021 |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

International application No.
PCT/JP2021/008009

C (Continuation). DOCUMENTS CONSIDERED TO BE RELEVANT

| Category* | Citation of document, with indication, where appropriate, of the relevant passages | Relevant to claim No. |
|---|---|---|
| A | JP 2012-68376 A (MITSUBISHI GAS CHEMICAL COMPANY, INC.) 05 April 2012 (2012-04-05), claim 1, paragraphs [0033]-[0035] | 1-12 |

Form PCT/ISA/210 (second sheet) (January 2015)

**INTERNATIONAL SEARCH REPORT**
Information on patent family members

International application No.
PCT/JP2021/008009

| | | |
|---|---|---|
| JP 2011-187824 A | 22 September 2011 | (Family: none) |
| JP 2013-124338 A | 24 June 2013 | (Family: none) |
| WO 2018/155013 A1 | 30 August 2018 | TW 201843183 A |
| JP 2014-82469 A | 08 May 2014 | US 2015/0185606 A1<br>claim 1, paragraphs [0156]-[0189]<br>WO 2014/050855 A1<br>KR 10-2015-0042823 A<br>TW 201413381 A |
| JP 2012-68376 A | 05 April 2012 | (Family: none) |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2013095833 A
- JP 2012068376 A
- JP H3287572 A
- JP 2003183246 A
- JP 2004051488 A

### Non-patent literature cited in the description

- *Journal of Materials Chemistry C,* August 2018